# EUROPEAN PATENT SPECIFICATION

(11) **EP 2 614 412 B1**
(45) Date of publication and mention of the grant of the patent: **12.07.2017**
(21) Application number: 10773397.4
(22) Date of filing: 06.09.2010
(51) Int. Cl.: G05B 19/00, G06F 1/16, H04B 1/38, H04L 12/26, H05K 1/14, H04L 29/08, H04L 12/40

(54) **MODULAR WIRELESS STATION FOR DATA ACQUISITION**
MODULARE DRAHTLOSSTATION ZUR DATENERFASSUNG
STATION SANS FIL MODULAIRE PERMETTANT UNE ACQUISITION DE DONNÉES

(43) Date of publication of application: 17.07.2013
(73) Proprietor: Paradox Engineering SA, 6883 Novazzano (CH)
(72) Inventor: MINETTI, Giovanni, CH-6877 Coldrerio (CH); CALABRO', Gaetano, I-22100 Como (IT)
(74) Representative: Zardi, Marco
(86) International application number: PCT/IB2010/054000
(87) International publication number: WO 2012/032375

(56) References cited:
- US-A1- 2002 153 419

## Description

### Field of application:

The present invention relates to a wireless data acquisition station and to a relative method for installing the wireless station.

In particular, the invention relates to a station of the type cited above, equipped with interfaces for detection sensors and with a transceiver module for the communication of the acquired data.

### Prior art

Wireless stations for acquiring data, for example for acquiring operating parameters of an industrial machine, of a photovoltaic or hydraulic plant, like the pressure or the temperature of a liquid, the power supply voltage of a circuit board or the charge level of a battery, are known. Such stations comprise one or more integrated detection sensors that can be interconnected to the machine or plant to be measured through a suitable interface, and comprise a transceiver module for the communication of the data to a monitoring station, which for example makes it possible to modify the operating parameters or to interrupt the industrial process. Some acquisition stations are equipped with just the interfaces for the detection sensors, since they are already available on the machine or on the plant to be monitored. In any case, every wireless station is structured and electronically set to acquire the data of one or more specific machines, through the aforementioned sensors and interfaces, and it is difficult to adapt it to acquire data from new machinery or operating parameters not previously foreseen.

Moreover, known stations suffer from some technical problems that limit or substantially complicate their use. Firstly, they are not simple to install and in most cases they require the intervention of a specialised and fully equipped worker who selects the sensors necessary for the detection and configures them, identifies the correct positioning of the station, for example fixing it on board the industrial machine and connecting its relative interface, as well as configuring the transceiver module. These operations are often complicated by the need to modify the wireless station, for example when it is necessary to acquire a different operating parameter of the machine to be monitored; in this case, the station must be removed and modified at the hardware and/or software level, by adding or configuring one or more additional sensors, and sometimes it is replaced by a more advanced station, substantially repeating all of the operations cited above.

Known stations are also susceptible to the weather conditions in which they operate, for example rain, wind, low or high temperatures and pressures, which can irreparably damage the electronic components, and they are not suitable for operating in environments in which there is a risk of explosion or fire, where a malfunction or short-circuit of the station can spread into the environment, causing substantial damage.

Further limitations derive from the difficulty in connecting a new wireless station in network with the stations already installed, also in this case needing the intervention of a worker, who configures an access point of the new wireless station to the network; it is also possible for a station to remain isolated, in the case in which the access point to the network is no longer available. Moreover, the limited range of the wireless station and the low charge autonomy prevent its use in quite isolated environments without an electric power supply to feed the battery.

US 2002/153419 discloses a wireless station with modules adapted to make a plug socket connection (0033, 0140).

The technical problem at the basis of the present invention is to devise a wireless station that is simple to install, without requiring the intervention of a specialised worker, both for its application and for the subsequent modifications that become necessary for example for different data acquisitions, also reducing the installation times, especially in dangerous environments, as well as to devise a station with long autonomy and with a wide range, having structural and functional characteristics that make it resistant to particular atmospheric conditions and to dangerous environments.

### Summary of the invention

The idea of solution at the basis of the present invention is to make a wireless data acquisition station having at least two simplified fast-coupling modules according to the features of claim 1. The modules are structured so that their mechanical and guided coupling makes both a hermetic and insulated closure from the outside but also a respective electrical connection that self-configures the stations in network with further wireless stations. Between the two modules it is possible to insert a plurality of additional interchangeable modules, equipped with interfaces for detector sensors and actuators, also quick coupling and simplified, simultaneously mechanical and electric, of the type quoted above. The guided coupling prevents an incorrect configuration of modules, as well as substantially simplifying and speeding up the application of the wireless station, also in low visibility conditions, in inaccessible locations or in the case of poor radio coverage. Damping means situated between the module and the respective electrical connectors are foreseen to reduce the stresses on these during the guided insertion of the modules, and improve the hold of the electrical connection, keeping the connectors inserted, with coupling completed. The coupled modules define one or more seats for receiving electrical means, insulated from the outside, making the wireless station resistant to atmospheric or dangerous environmental conditions; the seats are hydraulically insulated, allowing the installation of the wireless station underwater.

The wireless station has a substantially vertical extension, with a base or proximal module that acts as a power supply, both for a transceiver or distal module, and for additional modules or interface intermediates.

A connection bus common to all the modules is provided, substantially axial or parallel to the vertical axis of the wireless station, formed through the interconnection of the electrical connections of each module making up the station. In particular, the modules comprise a substantially cylindrical structure comprising a circuit board on which the electrical connector is situated, in a substantially axial or parallel position to the axis of the cylindrical structure; the quick and simplified coupling is carried out by inserting a portion having a reduced section of the cylindrical structure of one module into another module through a suitable guide and to a predetermined extent.

Based on this idea for a solution, the aforementioned technical problem is solved by a wireless station according to the features of claim 1. The wireless station comprises at least one transceiver module and a base module comprising a respective substantially hollow cylindrical structure and a plug or socket electrical connector fixed to the respective cylindrical structure, the cylindrical structure of one of the modules, for example of the base module, comprising a positioning guide for a guided axial insertion of a portion with reduced diameter of the cylindrical structure of the other module, i.e. of the transceiver, which makes a plug-socket connection between the modules. Respective hermetic closing lids are foreseen to close the part of the base and transceiver modules not involved in the coupling.

Advantageously, the mechanical and electrical connection of the modules is extremely simplified and quick, and it does not require the intervention of an equipped technician. Indeed, it is sufficient to slot the portion with reduced diameter of one module, for example of the transceiver, into the other module, i.e. the base module, rotate the transceiver module in the base module so that the positioning guide of the latter does not allow the guided axial insertion of the former, and insert the portion with reduced diameter of the transceiver module to a predetermined extent. Preferably, the insertion is limited by an abutment edge at which the electrical connection is also operative. According to an aspect of the invention, the wireless station comprises one or more additional modules, hereafter also indicated as interface modules, suitable for being arranged between the transceiver module and the base module, comprising a substantially hollow cylindrical structure, having a portion with reduced diameter and an opposite positioning guide, two electrical connectors, plug and socket, respectively facing towards opposite openings of the cylindrical structure of the additional modules, the cylindrical structures being able to be coupled, together or with the transceiver module and the base module, with axial insertion and guided by the positioning guides, to make plug-socket connections. When the modules are assembled, the wireless station activates and is automatically configured, and a CPU situated inside the transceiver module carries out an automatic search or "autodiscovery" of the modules installed.

Advantageously, the wireless station can be modified with substantial ease and speed, for example by adding or removing some interface modules, without requiring the intervention of a specialised technician; indeed, the additional modules are also coupled with the base module or with the transceiver module by slotting the portion with reduced diameter of one module, for example of the transceiver, into the other module, i.e. an additional module, rotating the transceiver module in the additional module, until the positioning guide of the latter does not allow the guided axial insertion of the former, and inserting the portion with reduced diameter of the transceiver module to a predetermined extent, up to the abutment edge, to also make the electrical connection.

The modules are interchangeable and can be mounted in any sequence, making the wireless station easy to fit together. Basically, one or more additional modules form a stack having two opposite additional modules, such a stack being able to be inserted between the base module and the transceiver module with axial insertion and guided by the positioning guides of the base module (insertion of the stack into the base module) and of one of said opposite additional modules (insertion of the transceiver into the stack).

According to a preferred embodiment, the transceiver module and/or the additional modules comprise a ring nut able to rotate around the cylindrical structure, having a tongue able to be inserted into the positioning guide of another module, and a radial serration suitable for engaging an annular sector of such a positioning guide, when the ring nut is rotated, to fix the transceiver module and/or the additional modules to another additional module and/or to said base module. The ring nut can be rotated, by engaging the radial serration in the annular sector, only when the electrical connection of the two modules involved in the coupling is achieved. Advantageously, the ring nut acts as a mechanical safety for the module but also ensures that the electrical connection inside the cylindrical structure, which is insulated and unable to be inspected from the outside, is made correctly. Preferably, the rotatable ring nut is a bayonet connection on the respective annular sector.

Each of the modules comprises at least one circuit board associated with the plug and/or socket and the interconnected plug and/or socket connectors form a vertical bus, substantially parallel or coaxial to the cylindrical structures and perpendicular to the circuit boards, for the interconnection and the communication between any two modules. The bus has an increasing length the more additional modules are interconnected between the base module and the transceiver. Advantageously, the bus is not limited to receiving a predetermined number of additional modules but is expandable through the insertion of the modules themselves and together with the wireless station.

The base module comprises the power supply module, comprising a long-life battery and an attachment base of the wireless station, which forms the aforementioned hermetic closure, and the transceiver module comprises low energy consumption transceiver means. Advantageously, the base can be fixed to the ground and the transceiver can face upwards, on top of the stack of additional modules possibly interposed, for optimal signal reception.

The insulation of the seats inside the wireless station is carried out through sealed joints arranged between each portion with reduced diameter and the circular structure of the module in which the portion with reduced section is inserted; in this way the space(s) defined by interconnecting the base module and the transceiver module, with/without interposition of the stack of additional modules, is/are hydraulically insulated.

The circuit boards are substantially circular and fixed to a radial thickness of the cylindrical structure, and elastic means are arranged between the boards and the radial thickness to dampen the plug-socket coupling. Advantageously, the dampers mitigate the stress on the circuit boards and on the plug-socket connectors during insertion, especially in the case in which such insertion is inappropriately forced or clumsy, or in the case in which the tolerances foreseen for the mechanical coupling between the positioning guide and the relative tongue do not immediately allow a perfect alignment between plug and socket, and it is necessary to make a reduced clearance between the two modules, with the tongue inserted in the guide, to make the definitive plug-socket electrical connection. Moreover, once the modules are inserted and electrically connected, the elastic means push the circuit board and the relative socket connector towards the circuit board and the relative plug connector of the other module, maintaining an optimal connection.

According to an aspect of the present invention, every circuit board comprises its own microprocessor having a connection interface, radially projecting from the radial sector of the circular structure. Advantageously, the resulting wireless station is a multiprocessor and multi-interface system and the network of interconnected and self-configured wireless stations is a distributed multiprocessor system.

According to an embodiment of the present invention, a wireless station comprises a single power supply module and a transceiver module and acts as a repeater of signals coming from another wireless station; preferably, the power supply module is the base module. Advantageously, the range of a first wireless station can be increased through the installation of further wireless stations self-configured in a network and situated within the radio coverage range, with one another and/or from the first station, which acts as a signal repeater. In this way, the wireless station can be reached even a substantial distance away.

According to a preferred embodiment of the invention, the circular structure is made from metallic material, resistant to temperatures of between -40 and +80 °C; preferably, the base can have a magnetic attachment system that allows attachment of the station without screws. Preferably, said material is anodized aluminium.

Further advantages and characteristics of the wireless station according to the present invention are clear from the description given hereafter with reference to the drawings, provided as an example and not for limiting purposes.

### Brief description of the drawings

Figure 1 is a front view of the wireless station according to the present invention;
figure 2 is a perspective section view of a transceiver module of the wireless station of figure 1;
figure 3 is a perspective section view of a base module of the wireless station of figure 1;
figure 4 is a front view of the wireless station according to a variant embodiment of the present invention;
figure 5 is a perspective section view of an additional module of the wireless station of figure 1;
figures 6a-6d schematically represent the steps of coupling two additional modules of the station of figure 1;
figure 7 is a section view of the additional module of figure 5;
figure 8 is a section view of a wireless station according to the present invention;
figures 9a-9b are perspective views of a ring nut of the wireless station of figure 1;
figures 10a-10b are views from above of the additional module of figure 5.

### Description of the invention

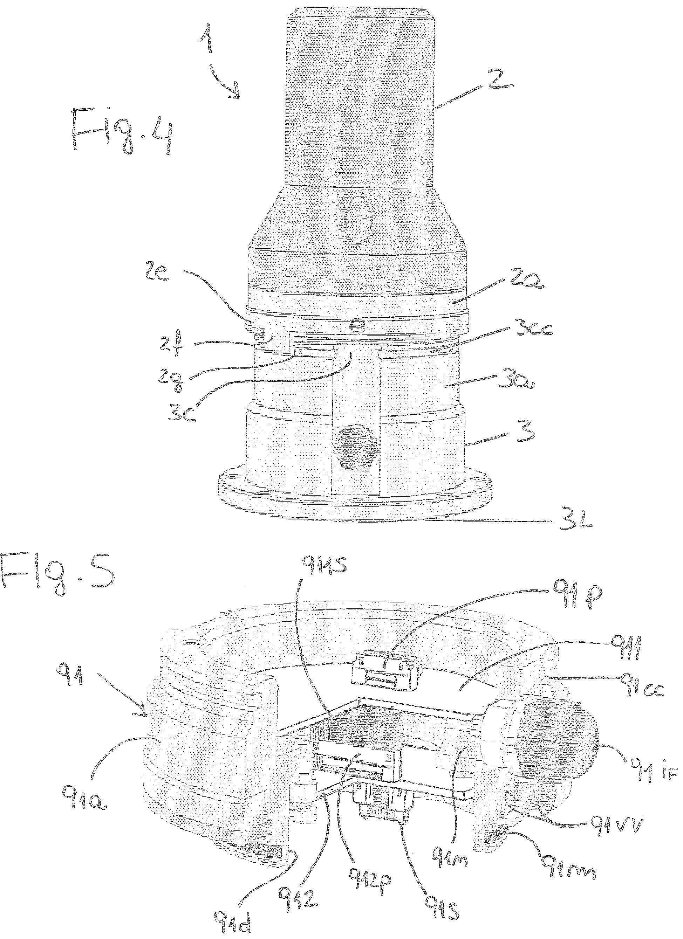

With reference to figure 4, reference numeral 1 schematically represents a wireless station for acquiring data according to the present invention, for example for acquiring operating parameters of an industrial machine, of a photovoltaic or hydraulic plant, like the pressure or temperature of a liquid, the power supply voltage of a circuit board or the charge level of a battery. Such examples of use do not limit the application of the wireless station 1, which can comprise many acquisition interfaces towards detection sensors situated on various apparatuses, machines or plants to be measured or integrated detection sensors; moreover, the station 1 comprises a transceiver module 2 for the communication of the acquired data to a monitoring station that makes it possible for example to modify the operating parameters or to interrupt the apparatuses, the machines or the industrial process, as will become clear later on in the description.

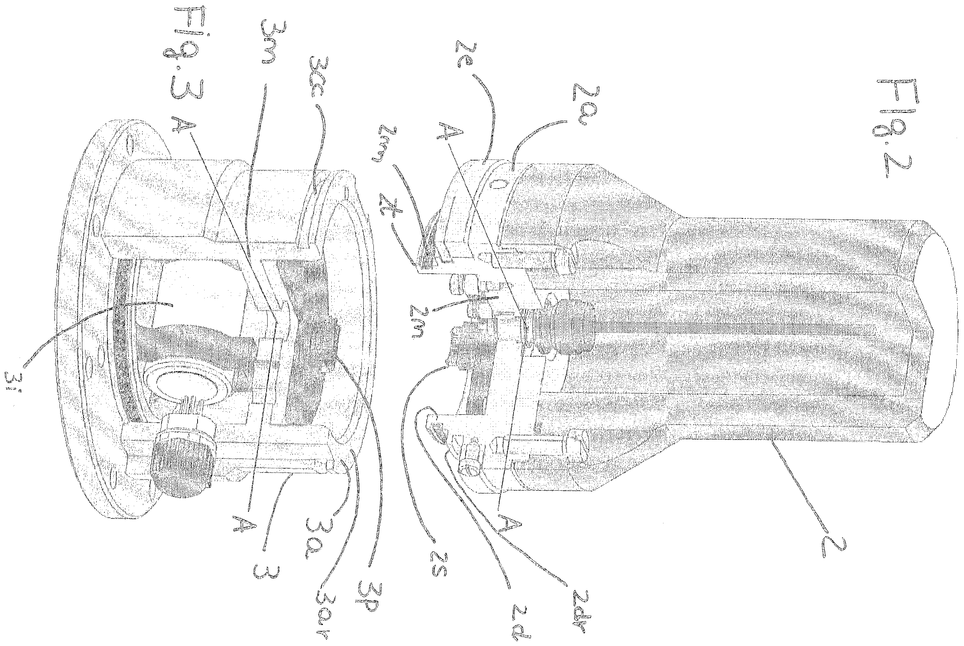

As represented in figures 2 and 3, the station 1 comprises at least one transceiver module 2 and a base module 3 having a respective substantially hollow cylindrical structure 2a, 3a and a plug 2s or socket 3p electrical connector fixed to the cylindrical structure; the structure 3a of one of the modules, for example of the base module 3, comprises a positioning guide 3c, clearly visible in figure 4, for a guided axial insertion of a portion with reduced diameter 2d of the structure 2a of the other module, i.e. of the transceiver module 2, that also makes a plug-socket connection between the modules 2 and 3. Substantially, the positioning guide 3c allows the insertion of the transceiver module 2 only with a predetermined mutual orientation in the base module, in which a tongue 2f of the transceiver module 2 is able to be inserted into the positioning guide 3c. According to a preferred embodiment, the tongue 2f is in a single piece with a ring nut 2e able to rotate around the cylindrical structure 2a and it has a radial serration 2g that engages an annular sector 3cc of the positioning guide 3c, when the ring nut 2e is rotated like in figure 4, to fix the transceiver module 2 to the base module 3.

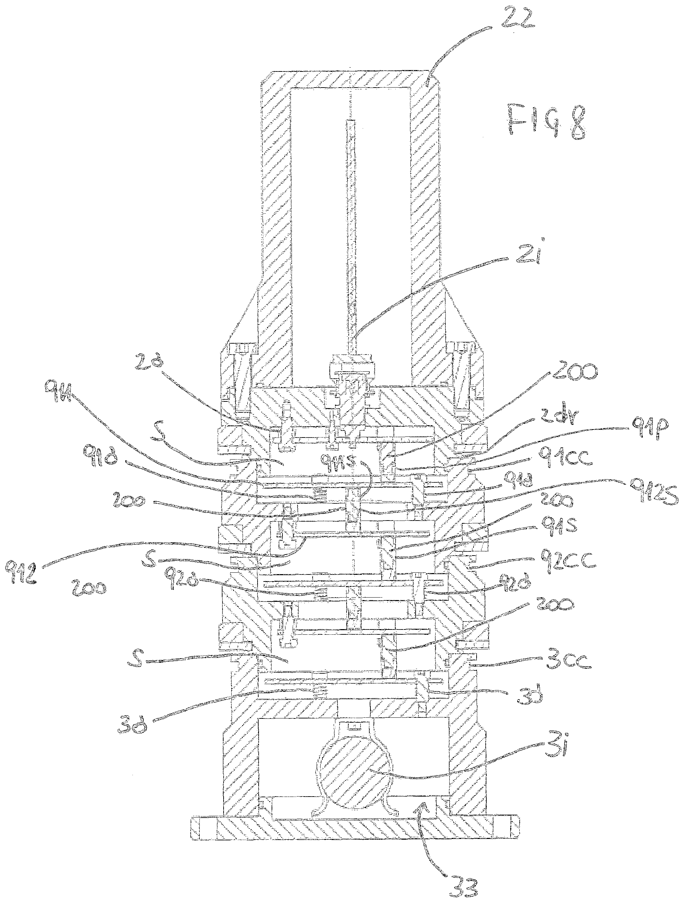

In figures 2 and 3 it can be seen that the portion with reduced diameter 2d is equipped with an abutment edge 2dr suitable for making an abutment on the surface 3ar of the circular structure 3a of the module 3, as can be seen more clearly in the section of figure 8 with parts inserted, limiting the insertion of the portion 2d in the structure 3a to a predetermined extent that also makes the plug-socket electrical connection of the two modules. Said predetermined extent ensures that the weight of the transceiver module 2 is supported by the circular structure 3a of the base module 3, without weighing down upon its socket connector, but that the plug connector 2s is operatively inserted into the socket connector. Only when the plug-socket electrical connection is made, the radial serration 2g of the tongue 2f can be engaged in the annular sector 3cc, which ensures the coupling. The closure of the ring nut 2e is preferably of the bayonet type.

The portion with reduced diameter 2d defines an annular seat for receiving a gasket 2m of the O-Ring type that operates between the inner surface of the circular structure 3a and the portion 2d, making a hermetic closure of a gap inside the wireless station 1. The O-Rings ensure a degree of protection IP67 resistant to dust and immersion in water up to a depth of at least one metre for at least about 30 minutes. An edge 2t of the portion 2d is preferably countersunk, forming a flaring for the insertion into the structure 3a.

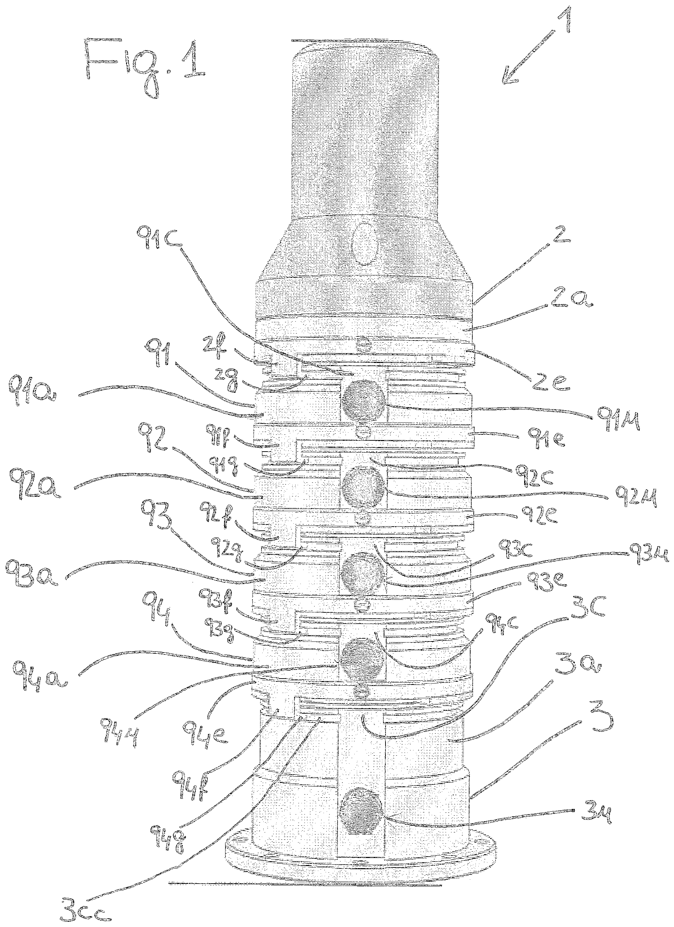

With reference to figure 1, it is clear that according to an aspect of the present invention, the wireless station is expandable through a plurality of additional or supplementary modules. The additional modules 91-94 are suitable for being arranged between the transceiver module 2 and the base module 3, and comprise a substantially hollow cylindrical structure 91a-94a , having a portion with reduced diameter 91d-94d and an opposite positioning guide 91c-94c, and two electrical connectors 91s,91p - 94s,94p, plug and socket, respectively facing towards opposite openings of the cylindrical structure 91a-94a of the additional modules 91-94. The cylindrical structures of the additional modules can be coupled, together or with the transceiver module 2 and the base module 3, with axial insertion and guided by the positioning guides 3c, 91c-94c, to make plug-socket connections. In particular, the example of figure 1 represents a base or proximal module 3 and a transceiver or distal module 2 between which four additional modules 91-94 are arranged: the transceiver module 2 is inserted into the additional module 91 with bayonet closure of the ring nut 2e and of the tooth 2g in the annular sector of the module 91; such a module 91 is in turn inserted into the additional module 92 with bayonet closure of the ring nut 91e and of the serration 91g in the annular sector of the module 92, which is inserted with analogous closure into the module 93, in turn inserted into the module 94; the latter is fixed, again with bayonet closure of the respective ring nut 94e and of the serration 94g in the annular sector 3cc of the base module 3.

The transceiver module 2 and/or the additional modules 91-94 comprise a ring nut 2e, 91e-94e able to rotate around the respective cylindrical structure 2a, 91a-94a, having a tongue 2f, 91f-94f able to be inserted into the positioning guide 3c, 91c-94c and a radial serration 91g-94g, suitable for engaging an annular sector 3cc, 91cc-94cc of the positioning guide 3c, 91c-94c, when the ring nut 2e, 91e-94e is rotated, fixing the transceiver module 2 and/or the additional modules 91-94 to another additional module 91-94 and/or to the base module 3.

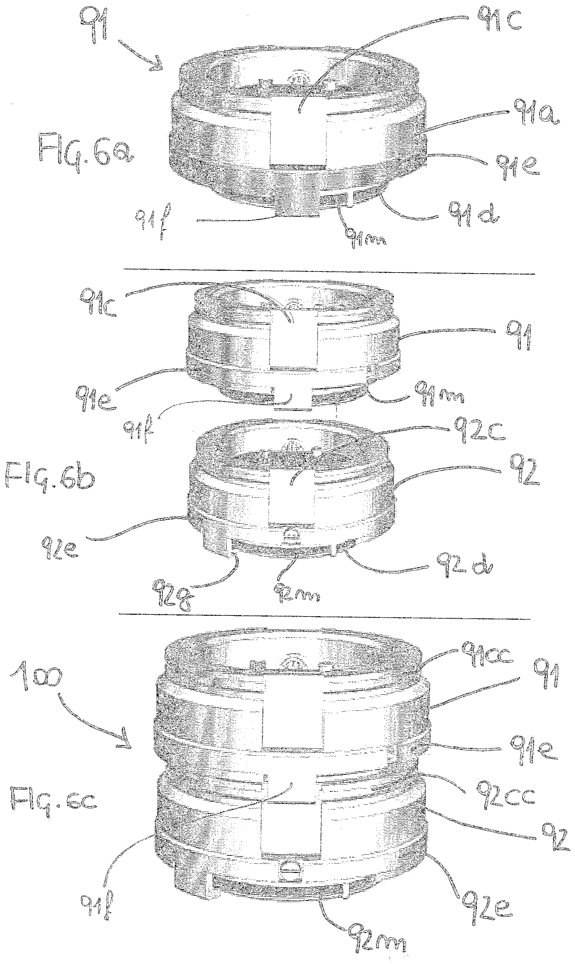

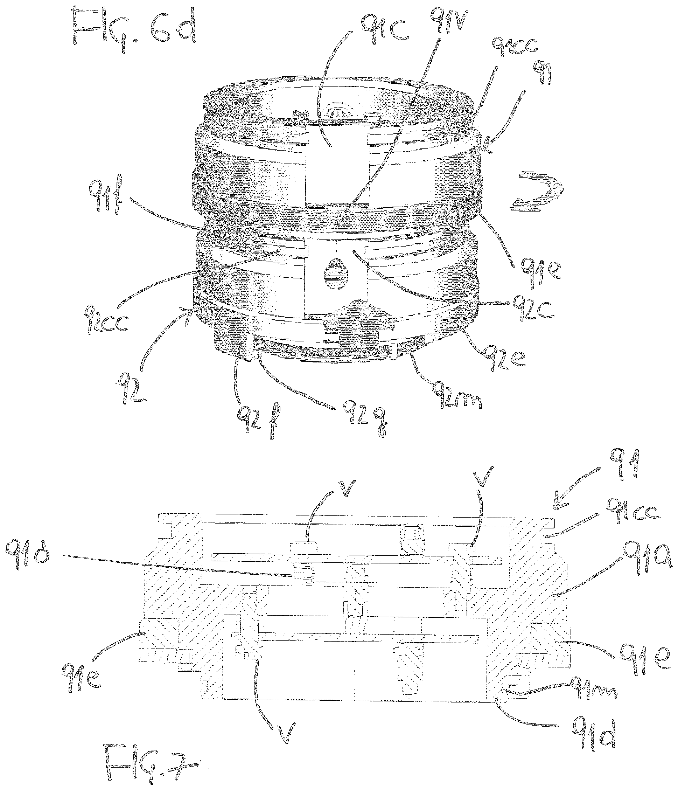

Figures 6a-6d schematically represent the quick and simplified coupling method of two additional modules 91 and 92 of figure 1. In particular, figure 6a represents just the module 91 that is intended to be inserted into the module 92 from the top towards the bottom (according to the direction of figures 6a-6d); the tongue 91f of the ring nut 91e is centred with respect to the positioning guide 91c, which is intended to receive the tongue 2f of the transceiver module 2 or of another additional module, not represented in figures 6a-6d. In figure 6b, it can be seen that an additional module 92 is oriented with respect to the module 91 in such a way that the positioning guide 92c, formed in a circumferential thickness of the cylindrical structure 92a, is centred and aligned on the tongue 91f of the additional module 91. The ring nut 92e is for example rotated and inserted into the annular sector of the base module 3 or of another additional module 93, not represented; of course, there is nothing to prevent the modules 91 and 92 from being coupled in a stack 100 before being inserted between the base module 3 and the transceiver module 2. Figure 6c represents the module 91, and in particular its portion with reduced diameter 91d, already inserted through the upper opening (direction of the figures) of the module 92, with the tongue 91f engaged in the guide 92c but not yet rotated; finally, figure 6d represents the rotated ring nut 91e and the radial serration 91g engaged in the annular sector 92cc. The cylindrical structure 92a comprises a pin that limits the rotation of the ring nut 91e around the circular structure 91 a to a predetermined angle β, preferably 45°, with respect to the guide 91c; in such a predetermined angle, a radial hole 91v of the ring nut 91 is centred on a corresponding hole 91w of the cylindrical structure 91a, visible in figure 5, through which it is possible to insert attachment means, for example a pin or a screw that acts as a safety, preventing accidental rotations of the ring nut 91e and consequent mechanical or electrical decouplings of the modules 91 and 92. If necessary, the attachment means are foreseen to be irremovable; it is also foreseen to use anti-tampering glues or welds. Such a coupling, described with reference to figures 6a-6d and to two additional modules 91-92, is substantially identical to the coupling of the transceiver module 2 directly on the base module 3, or of the transceiver module 2 on any additional module or of any additional module on the base module 3.

Substantially, one or more additional modules 91-94 of the type described above form a stack 100 of the type represented in figure 1 (with four additional modules) or in figure 8 (with two additional modules), having two opposite additional modules 91, 94. Such a stack 100 can be inserted between the base module 3 and the transceiver module 2 with axial insertion and guided by the positioning guides 3c of the base module 3 and of one of the opposite additional modules 91. In particular, the guide 3c of the module 3 guides the insertion of the module 94 and the guide 91c of the module 91 guides the insertion of the transceiver module 2.

The modules 2, 3, 91-94 comprise at least one circuit board 2h, 3h, 91h-94h on which the plug 2s, 91s-94s and/or socket 3p, 91p-94p connectors are situated; in particular, the interconnected plug and/or socket connectors form a bus 200, substantially parallel or coaxial to the cylindrical structures 2a, 3a, 91a-94a and perpendicular to the circuit boards 2h, 3h, 91h-94h, for the communication between any two modules 2, 3, 91-94, vertically expandable with the addition of additional modules. Preferably, the additional modules 91-94 are equipped with one or more interfaces towards detection sensors situated on the machines or the plants to be monitored, and comprise at least two circuit boards 911, 912 as represented in figure 5. On one side of the boards 911, 912 facing towards the openings of the module 91 there is the socket 91p and the plug 91s, which project towards such openings; on the other sides of the boards, those that are facing, there is the socket 911p and the plug 912s interconnected with one another, as is also clear from figure 8. The two boards 912 and 911 preferably comprise a respective processor. The boards depend on the reverse interface 91if for the machine or apparatus to be measured.

According to an aspect of the present invention the base module 3 is a power supply module comprising a long-life battery 3i and an attachment base 3L of the wireless station 1. The base 3L hermetically closes an opening 33 of the circular structure 3a of the base module 3 and comprises attachment means, for example a perforated flange or a magnetic material; it is also foreseen for the base 3L to be equipped with damping means to mitigate possible bumps and/or vibrations of the machine body or of the structure to which the wireless station is fixed. The inner battery supplies a voltage of 3.6V and guarantees a lifetime of at least 4 years; an adapter for a 12 to 24V DC/AC power supply is also foreseen, on the base module 3, in the case in which an external power supply is available.

Preferably, the power supply module has a diameter of about 0120 and a height of about H70 mm and weighs about 0.85 Kg. The microprocessor of the base module controls the absorption of current of the station 1 and supplies the residual capacity value, as well as the operating autonomy of the wireless station 1. The base module is programmed to receive an emergency hardware shut off signal; in this case the microcontroller interrupts the power supply voltage on the bus 200, through a Mosfet. It is foreseen to manually reset or reactivate the base module, which consists of disconnecting and reconnecting the power supply.

The long autonomy of the station and the lifetime of the battery are achieved by using specific hardware and software that reduces consumption and optimises efficiency. The battery is preferably a primary Lithium Tyonil Chloride stack of small dimensions and high energy; the battery supplies a maximum current of 100 mA even in the case of short-circuiting of the terminals. The technical specifications conform to the certification ATEX zone 0 and they make it possible to use the wireless station 1 even in the presence of mixtures of gas without the risk of causing explosions. The reduction of consumption of the battery is achieved through:
- use of electronic components having low consumption, both during normal operation, and in stand-by mode;
- "event-driven" communication over the bus 20 with interrupt hardware lines;
- power supply of the additional modules and relative sensors only for measurement;
- power supply, through the microcontroller of the additional module, of just the interfaces on the circuit board that are involved in the measurement;
- implementation of a transceiving protocol for the module 2 suitable for operating mainly in stand-by and with low consumption;
- use of fast ADCs (Analog to Digital Converters), to reduce the switching on time necessary for data sampling;
- management of the alarms mapped on interrupt;
- constant checking of the charge of the battery with a dedicated supervision system

Now with reference to the transceiver module 2 and to figure 2, it can be seen that such a module is equipped with transceiver means 2i; the cylindrical structure 2a of the transceiver module 2 is elongated to receive the antenna 2i, coaxial to it, and it is equipped with a hermetic closing lid 23.

The transceiver module 2 preferably has a diameter of 98 mm, a height of 145.5 mm and weighs about 0.9 Kg; for receiving-transmitting, it implements a protocol, preferably proprietary known as PE.Mesh, for the transmission of data over a Mesh network and for communication over the bus 200, with the additional modules 91-94 and the base module 3. In particular, the transmission of data is carried out with a Mesh protocol. The operating frequency is preferably 868/915 MHz; such a frequency has a high penetration factor in an industrial environment and operates in a licence-free ISM band with few users, compared to a 2,4GHz band normally used in similar applications.

The module 2 is equipped with an omnidirectional antenna consisting of a ¼ λ dipole, mounted on a connector TNC. The internal antenna is protected by a plastic radome with a sealing O-Ring, to protect the antenna from atmospheric agents. The dimensions of the dipole are set at the design stage, through a network analyst, to have the minimum SWR. The antenna has a 360° circular radiation diagram and makes connections at a maximum distance of at least 100-150 metres in open space. In an embodiment, an external directive antenna is also used, connected by cable coaxial to the same connector of the internal antenna; advantageously, the connector is coaxial to the cylindrical structure, and it is connected both to the internal antenna and to the external one, reducing the size of the module and simplifying the mechanical assembly operations.

In a radial thickness of the circular structure 3a with opening towards the outside, there is a light guide for diagnosing the state of the wireless station, for example carried out through a multi-colour LED. Preferably, the LED flashes during the installation or the reconfiguration of the wireless station and is switched off during normal operation, so as not to use up energy.

As already stated, sealing gaskets 2m, 91m-94m are arranged between every portion with reduced diameter 2d, 91d-94d and the circular structure 3a, 91a-94a of the module 3, 91-94 in which said portion 2d, 91d-94d is inserted, to hydraulically insulate the space S defined by interconnecting the base module 3 and the transceiver module 2, with possible interposition of the stack 100 of additional modules 91-94.

The circuit boards 2h, 3h, 91h-94h are substantially circular and fixed to a radial thickness 2n, 3n, 91n- 94n of the cylindrical structure, preferably through three screws V angularly offset by 120 °C. For the additional modules with double circuit board 911, 912 the three screws V of the board 911 are angularly offset by 60° with respect to the three screws V of the board 912, such screws abutting on opposite sides of the radial thickness. According to an aspect of the present invention, elastic means 2o, 3o, 91o-94o are arranged between the boards 2h, 3h, 91h-94h and the radial thickness 2n, 3n, 91n- 94n to reduce the stress on the boards and on the connectors during the plug-socket coupling. According to a preferred embodiment, the screws V have a threaded portion abutting on the radial thickness and a refaced portion, between the board and the radial thickness, on which a spring is slotted and operates. Advantageously, the spring is compressed by the board if during the insertion of the modules, the plug and the socket are not perfectly aligned; a minimum compression of the spring is in any case foreseen due to the friction between the socket connector and the plug connector.

Preferably, the diameter of the attachment holes of the boards is 5 mm and the diameter of the screws V is less, for example 3.95 mm, so as to allow a horizontal movement of the board that compensates for the assembly tolerances of the circular structures of the modules and the tolerances of the plug-socket connectors. The springs ensure the necessary elasticity of the overall structure of the wireless station and the height of the screws V simplifies the assembly steps, preventing the plug-socket connects from being able to accidentally unfasten, thus ensuring that the bus 200 is always electrically operative, even with many stacked modules. The plug and socket connectors are also equipped with a bevelled entry surface, which improves their coupling.

The additional modules 91-94 are input-output interface modules and they preferably have a diameter of 98mm, a height of 43 mm and they weigh 0.42 Kg; every module I/O inserted in the Node gives an increase in height equal to 36 mm. The interfaces towards the machines and the apparatuses to be measured are bidirectional and of various types, for example a 8-pole connector with M12. The interfaces have been studied considering those most common in industry, allowing the direct connection of most sensors and actuators. The analog and digital interfaces on the two internal circuit boards 911, 912 of each additional module can be directly connected with the external interfaces 91u-94u. The connection between the external connector M12 with 8 poles and the internal interfaces is made through micro-connectors, and it allows the personalization of the functions at the construction step of the different types of module.

Different additional modules can be used to acquire different operating parameters; the respective boards can be substantially structurally identical and electrically different, for the connection of different types of sensors. Vice-versa, in order to optimise warehouse storage, it is possible to make a certain number of modules comprising boards that are also electrically identical, to add or to deactivate undesired electrical components, before installation.

In an embodiment, the additional module comprises a single microprocessor situated on a first board with analog inputs and on the second board there are digital interfaces and the serial port RS232/485.

Preferably, each additional module comprises one or more of the following interfaces:
- 2 "Frequency Counter" digital inputs, with "pull-up" able to be activated through an internal micro "switch" for supplying clean contacts. The inputs are equipped with a low-pass filter with a cutoff frequency of 10KHz;
- 4 optoinsulated digital inputs, with input voltage 5-30Vdc, insulation 3000V and cutoff frequency 100Hz;
- 4 optoinsulated digital outputs, max 60Vdc 500mA;
- 1 input for a type K, J thermocouple, with temperature compensation, and 12bit resolution;
- 2 inputs of 0-20 mA / 4-20 mA with possibility of supplying the "loop", through internal micro "switch", "shunt" resistance 100 Ohm, and 12bit resolution;
- 2 common mode analog inputs 0-5Vdc, with 12bit resolution;
- 2 differential analog inputs ±10Vdc, with 12bit resolution;
- 1 serial port RS232/485.

The circuit boards 2h, 3h, 91h-94h comprise at least one microprocessor of their own and at least one sensor with the connection interface 3u, 91u-94u, preferably of the M12 type with 8 poles, projecting radially from the circular structure 3a, 91a-94a of the respective module 3, 91-94.

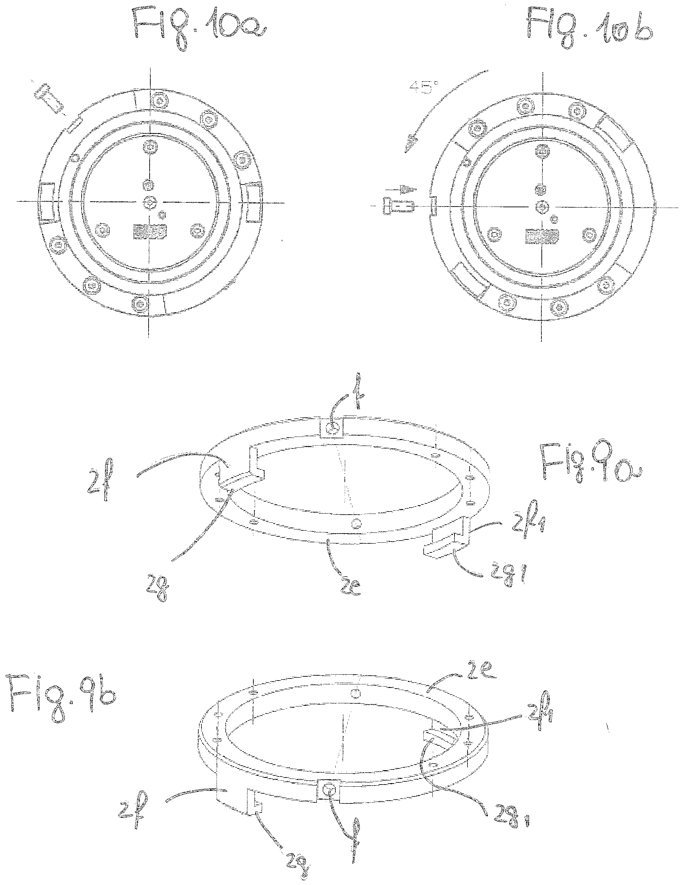

Figures 9a and 9b represent the ring nut, for example the ring nut 2e of the transceiver module; it is possible to clearly see the tongue 2f, the radial serration 2g, the radial hole f for attaching to the circular structure 2a. As stated above, the rotatable ring nut 2e forms a bayonet connection on the annular sector 3cc, 91cc-94cc. According to a preferred embodiment the ring nut 2e has two diametrically opposite tongues 2f and the positioning guides 3c, 91c-94c are formed in the thickness of the relative circular structure 3a, 91a-94a to receive both of the tongues 2f. In this case, the radial serrations 2g1, 2g2 of the tongues 2f, 2f1 simultaneously engage opposite portions of the annular sector 3cc, 91cc-94cc, improving the mechanical seal of the ring nut.

Advantageously, the wireless station according to the present invention is very simple to install and does not require the intervention of a specialised technician, both for its application and for its subsequent modifications that become necessary for example to acquire different data; the time necessary for the installation of the wireless station is substantially reduced, consequently also reducing the risks the workers are subjected to, especially in dangerous environments. The station has a long autonomy and a wide range, able to be amplified through self-configured wireless repeater stations on the Mesh radio network. The station is resistant to particular atmospheric conditions, to water, to rain, to wind, to the presence of oils and mineral or synthetic fats, to the presence of normal fuels, super fuels, diesel, paraffin, nitrogen or gas; moreover it can withstand immersion in water, for example up to a depth of a metre. The station is able to operate in dangerous and/or explosion risk environments since the electrical components situated inside the cylindrical structure are completely insulated from the outside.

## Claims

1. Wireless station (1) **characterised in that** it comprises at least one transceiver module (2) and a base module (3) comprising a respective hollow cylindrical structure (2a, 3a) and an electrical connector plug (2s) or socket (3p) fixed to the respective cylindrical structure, the cylindrical structure (3a) of one of said modules (3) comprising a positioning guide (3c) for a guided axial insertion of a portion with reduced diameter (2d) of the cylindrical structure (2a) of the other module (2) that makes a plug-socket connection between said modules, wherein the transceiver module (2) comprises a ring nut (2e) able to rotate around the cylindrical structure (2a), having a tongue (2f) able to be inserted into said positioning guide (3c) and a radial serration, adapted to engage an annular sector (3cc) of the positioning guide (3c) when the ring nut (2e) is rotated, to fix the transceiver module (2) to said base module (3), and wherein the wireless station includes a connection interface (3u) projecting radially from the cylindrical structure (3a),
wherein each of said modules (2, 3, 91-94) comprises at least one circuit board (2h, 3h) associated with the plug (2s) and/or with the socket (3p) and **in that** said interconnected plug and/or socket connectors form a bus (200), parallel or coaxial to said cylindrical structures (2a, 3a) and perpendicular to the circuit boards (2h, 3h), for the communication between any two modules (2, 3),
wherein said circuit boards (2h, 3h) are circular and fixed to a radial thickness (2n, 3n) of said cylindrical structure, elastic means (2o, 3o) being arranged between the boards (2h, 3h) and the radial thickness (2n, 3n) to dampen the plug-socket coupling, and
wherein each of said circuit boards (2h, 3h) comprises its own microprocessor and said connection interface (3u), including a M12
type with 8 poles.

2. Wireless station according to claim 1, **characterised in that** it comprises one or more additional modules (91-94) adapted to be arranged between the transceiver module (2) and the base module (3), comprising a hollow cylindrical structure (91a-94a), having a portion with reduced diameter (91d-94d) and an opposite positioning guide (91c-94c), two electrical connectors (91s,91p - 94s,94p), plug and socket, respectively facing towards opposite openings of the cylindrical structure (91a-94a) of said additional modules (91-94), said cylindrical structures being able to be coupled, with one another or with said transceiver module (2) and base (3), with axial insertion and guided by the positioning guides (3c, 91c-94c), to make plug-socket connections.

3. Wireless station (2) according to claim 2, **characterised in that** said one or more additional modules (91-94) form a stack (100) having two opposite additional modules (91, 94), said stack (100) being able to be inserted between the base module (3) and the transceiver module (2) with axial insertion and guided by the positioning guides (3c) of the base module (3) and of one of said opposite additional modules (91).

4. Wireless station (1) according to claims 2-3, **characterised in that** also said additional modules (91-94) comprise a ring nut (91e-94e) able to rotate around the cylindrical structure (91a-94a), having a tongue (91f-94f) able to be inserted into said positioning guide (91c-94c) and a radial serration (91g-94g), adapted to engage an annular sector (91cc-94cc) of the positioning guide (91c-94c) when the ring nut (91e-94e) is rotated, to fix the transceiver module (2) and/or the additional modules (91-94) to another additional module (91-94) and/or to said base module (3), and wherein a connection interface (91u-94u) project radially also from the cylindrical structures (91a-94a) of the additional modules (91-94).

5. Wireless station (1) according to claim 1-4, **characterised in that** the base module (3) is a power supply module comprising a battery (3i) and an attachment base (3L) of the wireless station (1), and the transceiver module (2) comprises transceiver means (2i).

6. Wireless station (1) according to claim 3, **characterised in that** it comprises gaskets (2m, 91m-94m) arranged between every portion with reduced diameter (2d, 91d-94d) and the cylindrical structure (3a, 91a-94a) of the module (3, 91-94) in which said portion (2d, 91d-94d) is inserted, to hydraulically insulate the space (S) defined interconnecting said base module (3) and said transceiver module (2), with or without interposition of said stack (100) of additional modules (91-94).

7. Wireless station (1) according to claim 1, **characterised in that** it comprises just one power supply module (3) and a transceiver module (2) that acts as a repeater of signals coming from another wireless station according to the previous claims, said power supply module (3) being the base module (2).

8. Wireless station according to claim 1, **characterised in that** said cylindrical structure is made from anodized aluminum.

9. Wireless station according to claim 1, **characterised in that** overall said base module (3) has one dimension of between 100 and 150 mm (diameter), one dimension (height) between 50 and 100mm and a weight of between about 0.50 and 1 Kg, said transceiver module (2) overall has one dimension of between 70 and 120 mm (diameter), one dimension (height) of between 120 and 160 mm and a weight of between 0.6-1.2 Kg, and said additional modules (91n- 94n) have one dimension of between 80 and 120 mm (diameter), one dimension (height) of between 30 and 60 mm and a weight of between 0.3 and 0.6 Kg.

10. Wireless station according to claim 4, **characterised in that** said rotary ring nut (2e, 91e-94e) forms a bayonet connection on said annular sector (3cc, 91cc-94cc).

11. Wireless station according to claim 1, wherein said transceiver module implements a data transceiving protocol on a Mesh Network and/or on said bus 200.

12. Wireless station according to claim 1, wherein said transceiver module comprises an omnidirectional internal antenna having a ¼ λ dipole and connected to the circuit board of the transceiver module (2) through a connector coaxial to the respective cylindrical structure (2a) and also a directive external antenna, connected to said connector of the internal antenna.

## Patentansprüche

1. Funkstation (1), **dadurch gekennzeichnet, dass** sie mindestens ein Transceiver-Modul (2) sowie ein Basismodul (3) aufweist, die jeweils eine hohle zylindrische Struktur (2a, 3a) und einen elektrischen Anschlusstecker (2s) oder eine Buchse (3p), der bzw. die an der jeweiligen zylindrischen Struktur fixiert ist, umfassen, wobei die zylindrische Struktur (3a) von einem der Module (3) eine Positionierungshilfe (3c) umfasst für eine geführte axiale Einführung eines Abschnitts (2d) der zylindrischen Struktur (2a) des anderen Moduls (2), der einen verringerten Durchmesser (2d) aufweist, die eine Steckverbindung zwischen den Modulen herstellt, wobei das Transceiver-Modul (2) eine Ringmutter (2e) umfasst, die in der Lage ist, sich um die zylindrische Struktur (2a) zu drehen, mit einer Zunge (2f), die in die Positionierungshilfe (3c) eingeführt werden kann, und einer Plan-Kerbverzahnung (2g), die dafür ausgelegt ist, mit einem ringförmigen Sektor (3cc) der Positionierungshilfe (3c) in Eingriff zu kommen, wenn die Ringmutter (2e) gedreht wird, um das Transceiver-Modul (2) am Basismodul (3) zu fixieren, und wobei die Funkstation eine Verbindungsschnittstelle (3u) beinhaltet, die von der zylindrischen Struktur (3a) radial übersteht,
wobei jedes von den Modulen (2, 3, 91-94) mindestens eine Leiterplatte (2h, 3h) umfasst, die zu dem Stecker (2s) und/oder zu der Buchse (3p) gehört, und wobei die miteinander verbundenen Stecker- und/oder Buchsenanschlüsse einen Bus (200) für die Kommunikation zwischen beliebigen zwei Modulen (2, 3) bilden, der parallel oder koaxial ist zu den zylindrischen Strukturen (2a, 3a) und senkrecht ist zu den Leiterplatten (2h, 3h),
wobei die Leiterplatten (2h, 3h) kreisförmig sind und an einer radialen Dicke (2n, 3n) der zylindrischen Struktur fixiert sind, wobei elastische Einrichtungen (2o, 2o) zwischen den Platten (2h, 3h) und der radialen Dicke (2n, 3n) angeordnet sind, um die Steckverbindung zu dämpfen, und
wobei jede von den Leiterplatten (2h, 3h) ihren eigenen Mikroprozessor umfasst und die Verbindungsschnittstelle (3u) einen M12-Typ mit 8 Polen beinhaltet.

2. Funkstation nach Anspruch 1, **dadurch gekennzeichnet, dass** sie ein oder mehrere zusätzliche Module (91-94) umfasst, die dazu ausgelegt sind, zwischen dem Transceiver-Modul (2) und dem Basismodul (3) angeordnet zu werden, und die eine hohle zylindrische Struktur (91a-94a) umfassen, die einen Abschnitt mit verringertem Durchmesser (91d-94d) und eine dazu entgegengesetzte Positionierungshilfe (91c-94c) und zwei elektrische Anschlüsse (91s, 91p - 94s, 94p), Stecker und Buchse, umfasst, die jeweils einander entgegengesetzten Öffnungen der zylindrischen Struktur (91a-94a) der zusätzlichen Module (91-94) zugewandt sind, wobei die zylindrischen Strukturen mit axialer Einführung und geführt durch die Positionierungshilfen (3c, 91c-94c) miteinander oder mit dem Transceiver-Modul (2) und der Basis (3) gekoppelt werden können, um Steckverbindungen herzustellen.

3. Funkstation (2) nach Anspruch 2, **dadurch gekennzeichnet, dass** das eine oder die mehreren zusätzlichen Module (91-94) einen Stapel (100) bilden, der zwei einander entgegengesetzte zusätzliche Module (91, 94) aufweist, wobei der Stapel (100) mit axialer Einführung und geführt durch die Positionierungshilfen (3c) des Basismoduls (3) und eines der einander entgegengesetzten zusätzlichen Module (91) zwischen das Basismodul (3) und das Transceiver-Modul (2) eingeführt werden kann.

4. Funkstation (1) nach den Ansprüchen 2-3, **dadurch gekennzeichnet, dass** auch die zusätzlichen Module (91, 94) eine Ringmutter (91e-94e) umfassen, die in der Lage ist, sich um die zylindrische Struktur (91a-94a) zu drehen, mit einer Zunge (91f-94f), die in die Positionungshilfe (91c-94c)eingeführt werden kann, und einer Plan-Kerbverzahhnung (91g-94g), die dafür ausgelegt ist, mit einem ringförmigen Sektor (91cc-94cc) der Positionierungshilfe (91c-94c) in Eingriff zu kommen, wenn die Ringmutter (91e-94e) gedreht wird, um das Transceiver-Modul (2) und/oder die zusätzlichen Module (91, 94) an einem anderen zusätzlichen Modul (91, 94) und/oder an dem Basismodul (3) zu fixieren, und wobei eine Verbindungsschnittstelle (91u-94u) auch von den zylindrischen Strukturen (91a-94a) der zusätzlichen Module (91, 94) radial übersteht.

5. Funkstation (1) nach Anspruch 1-4, **dadurch gekennzeichnet, dass** das Basismodul (3) ein Energieversorgungsmodul ist, das eine Batterie (3i) und eine Befestigungsbasis (3L) der Funkstation (1) umfasst, und das Transceiver-Modul (2) eine Transceiver-Einrichtung (2i) umfasst.

6. Funkstation (1) nach Anspruch 3, **dadurch gekennzeichnet, dass** sie Dichtungen (2m, 91m-94m) umfasst, die zwischen jedem Abschnitt mit verringertem Durchmesser (2d, 91d-94d) und der zylindrischen Struktur (3a, 91a-94a) des Moduls (3, 91-94), in die der Abschnitt (2d, 91d-94d) eingeführt wird, angeordnet sind, um den Raum (S), der so definiert ist, dass er das Basismodul (3) und das Transceiver-Modul (2) mit oder ohne Zwischenschaltung der Stapel (100) aus den zusätzlichen Modulen (91, 94) miteinander verbindet, hydraulisch zu isolieren.

7. Funkstation (1) nach Anspruch 1, **dadurch gekennzeichnet, dass** sie nur ein einziges Energieversorgungsmodul (3) sowie ein Transceiver-Modul (2) umfasst, das als Repeater von Signalen dient, die von einer anderen Funkstation gemäß den vorangehenden Ansprüchen kommen, wobei das Energieversorgungsmodul (3) das Basismodul (2) ist.

8. Funkstation nach Anspruch 1, **dadurch gekennzeichnet, dass** die zylindrische Struktur aus anodisiertem Aluminium besteht.

9. Funkstation nach Anspruch 1, **dadurch gekennzeichnet, dass** das Basismodul (3) insgesamt eine Abmessung zwischen 100 und 150 mm (Durchmesser) eine Abmessung (Höhe) zwischen 50 und 100 mm und ein Gewicht zwischen etwa 0,50 und 1 kg aufweist, wobei das Transceiver-Modul (2) insgesamt eine Abmessung zwischen 70 und 120 mm (Durchmesser), eine Abmessung (Höhe) zwischen 120 und 160 mm und ein Gewicht zwischen 0,6-1,2 kg aufweist und die zusätzlichen Module (91n-94n) eine Abmessung zwischen 80 und 120 mm (Durchmesser), eine Abmessung (Höhe) zwischen 30 und 60 mm und ein Gewicht zwischen 0,3 und 0,6 kg aufweisen.

10. Funkstation nach Anspruch 4, **dadurch gekennzeichnet, dass** die rotierende Ringmutter (2e, 91-94e) eine Bajonettverbindung an dem ringförmigen Sektor (3cc, 91cc-94cc) bildet.

11. Funkstation nach Anspruch 1, wobei das Transceiver-Modul ein Datensende-/Datenempfangsprotokoll an einem Mesh-Netz und/oder an dem Bus 200 implementiert.

12. Funkstation nach Anspruch 1, wobei das Transceiver-Modul eine omnidirektionale interne Antenne mit einem 1/4-λ-Dipol, die durch einen Verbinder, der koaxial ist zu der jeweiligen zylindrischen Struktur (2a), mit der Leiterplatte des Transceiver-Moduls (2) verbunden ist, und auch eine mit dem Verbinder der internen Antenne verbundene externe Richtantenne umfasst.

## Revendications

1. Station sans fil (1) **caractérisée** en qu'elle comprend au moins un module émetteur-récepteur (2) et un module de base (3) comportant une structure cylindrique creuse respective (2a, 3a) et une fiche (2s) ou une embase (3p) de connecteur électrique fixée à la structure cylindrique respective, la structure cylindrique (3a) de l'un desdits modules (3) comprenant un guide de positionnement (3c) pour permettre une insertion axiale guidée d'une partie ayant un diamètre réduit (2d) de la structure cylindrique (2a) de l'autre module (2) qui réalise une connexion mâle-femelle entre lesdits modules, dans laquelle le module émetteur-récepteur (2) comprend un écrou à oeillet (2e) qui peut tourner autour de la structure cylindrique (2a), ayant une languette (2f) qui peut être insérée dans ledit guide de positionnement (3c) et une dentelure radiale, conçue pour venir en contact avec un secteur annulaire (3c) du guide de positionnement (3c) lorsque l'écrou à oeillet (2e) est tourné, pour fixer le module émetteur-récepteur (2) au dit module de base (3) et dans laquelle la station sans fil comprend une interface de connexion (3u) faisant saillie radialement depuis la structure cylindrique (3a),
dans laquelle chaque module (2, 3, 91 à 94) comprend au moins une carte de circuit imprimé (2h, 3h) associée à la fiche (2s) et/ou à l'embase (3p) et en ce que lesdits connecteurs de fiche et/ou d'embase interconnectés forment un bus (200), parallèle ou coaxial auxdites structures cylindriques (2a, 3a) et perpendiculaire aux cartes de circuit imprimé (2h, 3h) pour permettre la communication entre deux modules quelconques (2, 3),
dans laquelle lesdites cartes de circuit imprimé (2h, 3h) sont circulaires et fixées à une épaisseur radiale (2n, 3n) de ladite structure cylindrique, des moyens élastiques (2o, 3o) étant disposés entre les cartes (2h, 3h) et l'épaisseur radiale (2n, 3n) pour amortir le couplage mâle-femelle, et
dans laquelle chacune desdites cartes de circuit imprimé (2h, 3h) comprend son propre microprocesseur et ladite interface de connexion (3u), comprenant un type M12 ayant 8 pôles.

2. Station sans fil selon la revendication 1, **caractérisée en ce qu'**elle comprend un ou plusieurs modules supplémentaires (91 - 94) conçus pour être disposés entre le module émetteur-récepteur (2) et le module de base (3), comprenant une structure cylindrique creuse (91a à 94a), ayant une partie présentant un diamètre réduit (91d à 94d) et un guide de positionnement opposé (91c à 94c), deux connecteurs électriques (91s, 91p - 94s, 94p), une fiche et une embase, faisant respectivement face à des ouvertures opposées de la structure cylindrique (91a à 94a) desdits modules supplémentaires (91 à 94), lesdites structures cylindriques pouvant être couplées les unes aux autres ou au dit module émetteur-récepteur (2) et à ladite base (3), avec une insertion axiale et guidées par les guides de positionnement (3c, 91c à 94c), pour réaliser des connexions mâle-femelle.

3. Station sans fil (2) selon la revendication 2, **caractérisée en ce que** ledit ou lesdits modules supplémentaires (91 à 94) forment un empilement (100) ayant deux modules supplémentaires opposés (91, 94), ledit empilement (100) pouvant être inséré entre le module de base (3) et le module émetteur-récepteur (2) avec une insertion axiale et guidé par les guides de positionnement (3c) du module de base (3) et de l'un desdits modules supplémentaires opposés (91).

4. Station sans fil (1) selon les revendications 2 à 3, **caractérisée en ce que** lesdits modules supplémentaires (91 à 94) comprennent également un écrou à oeillet (91e à 94e) qui peut tourner autour de la structure cylindrique (91a à 94a), ayant une languette (91f à 94f) qui peut être insérée dans ledit guide de positionnement (91c à 94c) et une dentelure radiale (91g à 94g), conçue pour venir en contact avec un secteur annulaire (91cc à 94cc) du guide de positionnement (91c à 94c) lorsque l'écrou à oeillet (91e à 94e) est tourné, pour fixer le module émetteur-récepteur (2) et/ou les modules supplémentaires (91 à 94) à un autre module supplémentaire (91 à 94) et/ou au dit module de base (3) et dans laquelle une interface de connexion (91u à 94u) fait saillie radialement également depuis les structures cylindriques (91a à 94a) des modules supplémentaires (91 à 94).

5. Station sans fil (1) selon les revendications 1 à 4, **caractérisée en ce que** le module de base (3) est un module d'alimentation électrique comprenant une batterie (3i) et une base de fixation (3L) de la station sans fil (1) et le module émetteur-récepteur (2) comprend un moyen émetteur-récepteur (2i).

6. Station sans fil (1) selon la revendication 3, **caractérisée en ce qu'**elle comprend des joints d'étanchéité (2m, 91m à 94m) disposés entre chaque partie ayant un diamètre réduit (2d, 91d à 94d) et la structure cylindrique (3a, 91a à 94a) du module (3, 91 à 94) dans lequel ladite partie (2d, 91d à 94d) est insérée, pour isoler hydrauliquement l'espace (S) défini interconnectant ledit module de base (3) et ledit module émetteur-récepteur (2), avec ou sans interposition dudit empilement (100) de modules supplémentaires (91 à 94).

7. Station sans fil (1) selon la revendication 1, **caractérisée en ce qu'**elle comprend juste un seul module d'alimentation électrique (3) et un module émetteur-récepteur (2) qui fait office de répéteur de signaux provenant d'une autre station sans fil selon les revendications précédentes, ledit module d'alimentation électrique (3) étant le module de base (2).

8. Station sans fil selon la revendication 1, **caractérisée en ce que** ladite structure cylindrique est réalisée en aluminium anodisé.

9. Station sans fil selon la revendication 1, **caractérisée en ce qu'**en général ledit module de base (3) présente une dimension comprise entre 100 et 150 mm (diamètre), une dimension (hauteur) comprise entre 50 et 100 mm et un poids compris entre 0,50 et 1 kg, ledit module émetteur-récepteur (2) présente en général une dimension comprise entre 70 et 120 mm (diamètre), une dimension (hauteur) comprise entre 120 et 160 mm et un poids compris entre 0,6 et 1,2 kg et lesdits modules supplémentaires (91n à 94n) présentent une dimension comprise entre 80 et 120 mm (diamètre), une dimension (hauteur) comprise entre 30 et 60 mm et un poids compris entre 0,3 et 0,6 kg.

10. Station sans fil selon la revendication 4, **caractérisée en ce que** ledit écrou à oeillet rotatif (2e, 91e à 94e) forme une connexion baïonnette sur ledit secteur annulaire (3cc, 91cc à 94cc).

11. Station sans fil selon la revendication 1, **caractérisée en ce que** ledit module émetteur-récepteur met en oeuvre un protocole d'émission-réception de données sur un réseau maillé et/ou sur ledit bus (200).

12. Station sans fil selon la revendication 1, **caractérisée en ce que** ledit module émetteur-récepteur comprend une antenne interne omnidirectionnelle ayant un dipôle ¼ λ et raccordée à la carte de circuit imprimé du module émetteur-récepteur (2) au moyen d'un connecteur coaxial à la structure cylindrique respective (2a) et également une antenne directive externe raccordée audit connecteur de l'antenne interne.
